Europäisches Patentamt

European Patent Office

Office européen des brevets

(11) Numéro de publication: **0 368 768 B1**

(12) **FASCICULE DE BREVET EUROPEEN**

(45) Date de publication de fascicule du brevet: **25.05.94**  (51) Int. Cl.⁵: **H01L 21/22**, H01L 29/167, H01L 29/36, H01L 29/91

(21) Numéro de dépôt: **89420425.4**

(22) Date de dépôt: **06.11.89**

(54) **Procédé de fabrication d'une diode rapide et diode rapide obtenue par ce procédé.**

(30) Priorité: **09.11.88 FR 8815728**

(43) Date de publication de la demande:
**16.05.90 Bulletin 90/20**

(45) Mention de la délivrance du brevet:
**25.05.94 Bulletin 94/21**

(84) Etats contractants désignés:
**DE FR GB IT NL**

(56) Documents cités:
**EP-A- 0 090 722
EP-A- 0 135 733**

**JOURNAL OF ELECTROCHEMICAL SOCIETY,
vol. 114, no. 12, décembre 1967, pages
1287-1292; E.D. WOLLEY et al.: "Formation of
precipitates in gold diffused silicon"**

(73) Titulaire: **SGS-THOMSON MICROELECTRO-
NICS S.A.
7, Avenue Galliéni
F-94250 Gentilly(FR)**

(72) Inventeur: **Follegot, Jean-Pierre
4, Place Victor Jacquemont
F-37200 Tours(FR)**

(74) Mandataire: **de Beaumont, Michel
1bis, rue Champollion
F-38000 Grenoble (FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention concerne le domaine des semiconducteurs et notamment des procédés de diffusion de métaux tels que l'or dans du silicium.

Dans de nombreux types de composants semiconducteurs, et notamment dans des composants de puissance, on cherche à réduire la durée de vie des porteurs minoritaires dans une couche semiconductrice particulière. Pour cela, on crée dans ces couches des centres de recombinaison des porteurs. De tels centres de recombinaison peuvent correspondre à des sites dans lesquels on a effectué des diffusions d'or ou de platine, ou à des sites dans lesquels on a créé des dislocations, par exemple par implantation d'électrons, de protons, d'ions...

Avec les procédés du type implantation ionique, protonique ..., il est théoriquement possible d'obtenir des densités de dislocation plus importantes à des profondeurs choisies dans une couche ou tranche semiconductrice en sélectionnant le mode d'implantation. Néanmoins, de tels procédés ne permettent pas d'atteindre des durées de vie très faibles. Ainsi, pour l'obtention de durées de vie très faibles, on est classiquement amené à utiliser des procédés du type diffusion d'or, mais il n'est pas possible avec les procédés connus de moduler la concentration en or dans le sens de l'épaisseur de la couche ou tranche semiconductrice dans laquelle la diffusion est effectuée.

Ainsi, la présente invention propose d'une part un procédé permettant d'effectuer une telle modulation de la concentration en atomes d'or, pour réaliser une diode rapide à performances améliorées.

Pour atteindre ces objets, la présente invention prévoit un procédé de modulation de la quantité d'un métal tel que l'or diffusé dans un substrat de silicium, pour former une diode rapide, en utilisant le phénomène de dépendance entre les concentrations d'or et de phosphore dans un substrat de silicium décrit dans "Journal of the Electrochemical Society", vol. 114, No. 12, décembre 1967, PP 1287-1292. Ce procédé est exposé en revendication 1.

Des modes de réalisation de ce procédé sont exposés dans les revendication 2 et 3.

La présente invention vise également une diode rapide PNN+ obtenue par le procédé susmentionné. Cette diode est exposée en revendication 4, des modes de réalisation de cette diode étant exposés dans les revendications 5 et 6.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1A représente schématiquement une vue en coupe d'une structure semiconductrice N⁻NN⁻ ;

les figures 1B et 1C représentent des courbes de concentration de phosphore, de concentration d'or et de durée de vie relatives à la structure de la figure 1A ;

les figures 2 à 6 sont destinées à décrire l'état de la technique et les problèmes qui se posent pour la réalisation d'une diode rapide et correspondant aux figures 1 à 5 de la demande de brevet européen EP-A 0 090 722 déposée au nom de Thomson CSF et dont l'inventeur est Yoland Collumeau ;

la figure 7 représente une vue en coupe d'une structure selon la présente invention ; et

les figures 8 et 9 représentent des profils de dopage correspondant à la figure 7.

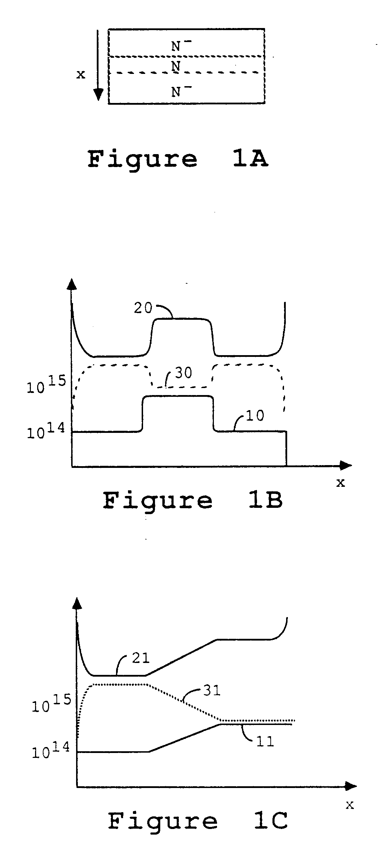

Ainsi, la figure 1A représente une vue en coupe schématique d'un substrat semiconducteur comprenant en superposition une couche N⁻, c'est-à-dire une couche N à faible niveau de dopage, une couche N et une couche N⁻.

La courbe 10 de la figure 1B représente le profil de dopage de cette structure dans la direction de la flèche x de la figure 1A. On suppose que les couches N⁻ ont une concentration de porteurs indiquée par la courbe 10 de l'ordre de $10^{14}$ atomes/cm$^3$ et la couche N une concentration de porteurs de l'ordre de $10^{15}$ atomes/cm$^3$ et que le dopant conférant la conductivité de type N est du phosphore.

Dans ce cas, si l'on réalise dans la structure de la figure 1A une diffusion d'or, on constate que cette diffusion présente un profil correspondant à celui de la courbe 20 à savoir que la diffusion d'or présente des centres actifs là où l'or est placé dans des positions substitutionnelles et non pas dans des positions interstitielles réparties.

Comme le montrent les courbes 10 et 20, la concentration en atomes d'or disposés de façon substitionnelle suit le profil de la concentration en phosphore. Les essais effectués par la demanderesse montrent que cette relation reste vraie dans le mesure où la concentration de phosphore varie entre $10^{13}$ et $10^{15}$ atomes/cm3. On dispose ainsi d'un moyen pour moduler la concentration en centres de recombinaison par diffusion d'or en ayant réalisé au préalable des gradients de diffusion de phosphore. On notera que, de façon classique, la concentration d'or est plus élevée vers les faces de la structure.

La figure 1C représente par la courbe 11 le profil de concentration d'une structure du même type où l'on trouve une couche inférieure de type N dont le niveau de dopage est de l'ordre de $10^{14}$ atomes/cm3 et une couche supérieure qui présente une concentration de l'ordre de $10^{15}$ atomes/cm3,

la couche intermédiaire présentant un niveau de dopage au phosphore variant graduellement entre $10^{14}$ et $10^{15}$. De même, la concentration d'atomes d'or présentée par la courbe 21 suit cette concentration. Dans les figures 1B et 1C, les courbes 30 et 31 représentent les durées de vie correspondantes dans les diverses couches après la diffusion d'or, ces durées de vie étant inversement proportionnelles à la concentration en atomes d'or substitutionnels.

Cette possibilité de modulation dans le sens de l'épaisseur d'une tranche semiconductrice de la concentration en atomes d'or, c'est-à-dire de la concentration en centres de recombinaison et donc de modulation de la durée de vie des porteurs, peut présenter de nombreuses applications dans le domaine des composants semiconducteurs et notamment des composants de puissance. On va décrire ci-après, une application inventive particulière aux diodes rapides, cette application n'étant pas limitative des applications possibles de la présente invention.

Une étude détaillée des paramètres influant sur la fabrication des diodes rapides est exposée dans la demande de brevet européen EP-A-0 090 722 déposée au nom de Thomson CSF, l'inventeur étant Yoland Collumeau.

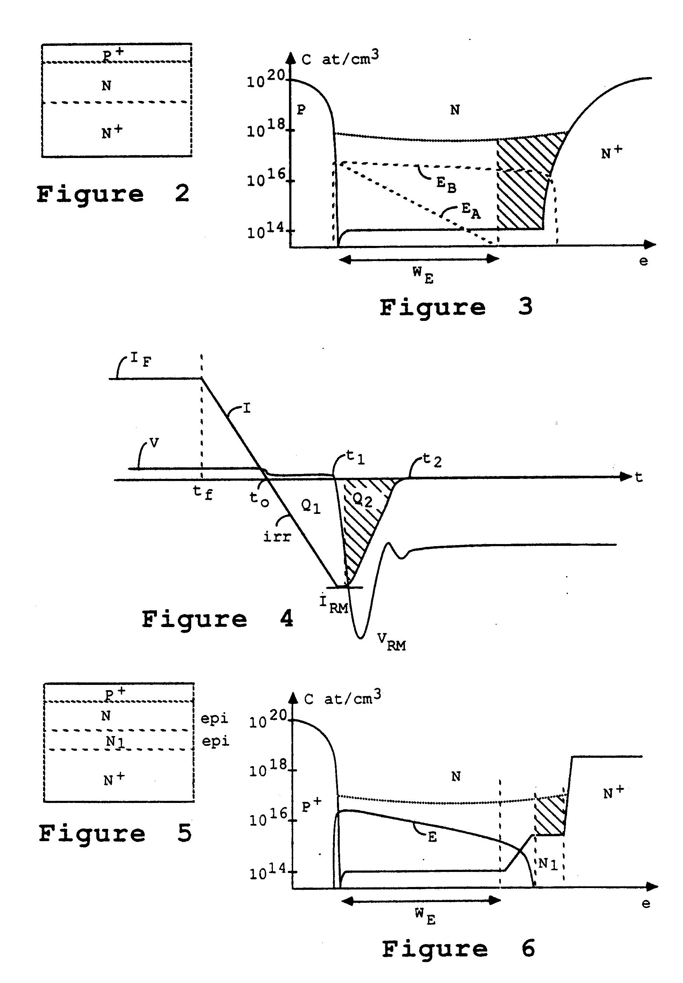

Les problèmes posés par la réalisation de diodes rapides sont exposés en relation avec les figures 2 à 6 de la présente demande qui correspondent aux figures 1 à 5 de la demande de brevet susmentionnée.

Comme le montre la figure 2, une diode rapide comprend classiquement une structure P + NN + .

La figure 3 indique en traits pleins la concentration des atomes dopants dans une telle diode. Comme l'indique la courbe en pointillés de cette figure 3, lorsqu'un courant direct passe dans cette diode, une certaine quantité de charges est injectée dans la zone faiblement dopée de type N. Cette quantité de charges ou de porteurs injectés dépend du courant traversant la diode. La quantité de charges emmagasinée pendant la conduction directe et demeurant à l'instant $t_0$ du cycle de commutation est couramment désignée par le symbole $Q_0$ et est appelée charge stockée. Elle s'exprime par une relation du type :

$$Q_0 \sim \tau I_F \text{ ou } Q_0 \sim \tau^2 \, dI_F/dt$$

selon la valeur de la durée $t_0 - t_F$ par rapport à la valeur de $\tau$ où $\tau$ est la durée de vie des porteurs minoritaires dans la zone de type N de la diode et où $I_F$ est le courant direct dans la diode.

Quand on inverse la tension aux bornes du circuit comprenant la diode ou que le courant est dérivé dans une autre partie du circuit, on ne retrouve pas immédiatement aux bornes de cette diode une tension de valeur égale à celle de la tension inverse appliquée. Au contraire, il s'écoule un certain temps durant lequel la diode peut être assimilée à un court-circuit en inverse, avant qu'elle ne retrouve son pouvoir de blocage.

En effet, pendant la commutation, pour une diode rapide, une partie de la charge $Q_0$ disparaît spontanément par recombinaison interne (liée à la durée de vie des porteurs minoritaires), mais l'autre partie, appelée charge recouvrée $Q_R$, qui intervient essentiellement dans le phénomène étudié est évacuée par le courant inverse circulant dans la diode. C'est cette charge recouvrée qui produit le courant inverse de recouvrement et induit tous les phénomènes de commutation (surtension, échauffement, parasites, etc...).

Le recouvrement inverse peut être décomposé en deux parties (voir aussi la figure 4).

Dans la première partie, dès l'instant de fermeture $t_F$ de l'interrupteur du circuit de commutation, le courant direct commence à décroître, s'annule et un courant inverse $i_{rr}$ s'établit. La vitesse de décroissance du courant direct, puis de croissance du courant inverse, est en général exclusivement imposée par le circuit dans lequel est insérée la diode. Pendant cette première partie, une quantité de charges $Q_1$ est évacuée.

A partir de l'instant $t_1$, la diode retrouve son pouvoir de blocage. Le courant inversé va commencer à décroître. Les abords de la jonction deviennent libres de porteurs (création d'une zone déserte ou zone de charge d'espace). Il reste à évacuer une charge Q2 correspondant à la zone hachurée en figure 4 tandis que le courant inverse décroît et s'annule.

Finalement, après l'instant $t_2$, la variation de courant étant nulle, il ne reste aux bornes de la diode que la tension inverse appliquée.

Pour déterminer plus exactement le fonctionnement, il convient d'examiner à quels paramètres physiques correspondent les charges $Q_1$ et Q2. On considérera l'allure de la zone déserte ou zone de charge d'espace dans la diode dans deux cas particuliers. En figure 3, on a reporté en pointillés des courbes $E_A$ et EB indiquant la distribution du champ électrique quand la diode est dans l'état bloqué. Dans le cas de la courbe $E_A$, l'épaisseur de la zone N est supérieure à la largeur $W_E$ de la zone déserte. Dans le cas de la courbe $E_B$, la zone déserte s'étend sur toute l'épaisseur de la zone N.

Pendant la période s'étendant entre les instants $t_0$ et $t_1$, on élimine notamment tous les porteurs injectés qui se trouvent dans la région dans laquelle se développe la zone de charge d'espace. Dans le cas de la courbe $E_A$ (couche N épaisse devant l'étendue de la zone déserte) il va rester des porteurs injectés après cette première phase et la

charge $Q_2$ correspond à des porteurs qui se trouvaient dans la zone hachurée de la figure 3. Dans le cas de la courbe $E_B$, la charge Q2 est pratiquement nulle et en conséquence la durée s'écoulant entre les instants $t_1$ et t2 est très brève : le courant inverse passe très vite de son amplitude maximale $I_{RM}$ à une valeur nulle. Il résulte de cette variation très rapide du courant la création de surtensions $V_{RM}$ importantes et la naissance d'oscillations en courant et en tension.

Pour réaliser en pratique une diode rapide pour laquelle la charge d'espace a la configuration indiquée par la courbe $E_A$, on part de la tension inverse à obtenir. Celle-ci détermine la résistivité du silicium N à utiliser. Cette donnée étant acquise, on calcule l'extension de la charge d'espace $W_E$ et on choisit l'épaisseur de la couche N, $W_N$, supérieure à $W_E$. On procède en final à une réduction de la durée de vie $\tau$ des porteurs minoritaires (diffusion d'or ou de platine ; bombardement électronique...) ; c'est en effet cette donnée physique qui, pour des conditions $I_F$ et $dI_F/dt$ données, gère la quantité de charges stockées $Q_0$ et, à partir de là, la rapidité de commutation de la diode ($t_1$-$t_0$, $t_2$-$t_0$, $I_{RM}$). On ne peut pas réduire à volonté la durée de vie. Pour que la diode conserve des caractéristiques correctes à l'état conducteur (caractéristiques $V_F = f(IF)$) on est tenu de maintenir la durée de vie au dessus d'une valeur minimale qui dépend essentiellement de l'épaisseur $W_N$ de la couche N centrale et dont la valeur minimale est proportionnelle à $W_N^2$. On ne peut donc réduire au-delà d'un certain seuil la charge $Q_0 \sim \tau I_F$ et partant le temps de recouvrement de la diode.

Ainsi pour réduire $Q_0$, il faut pouvoir réduire la durée de vie et donc l'épaisseur de la couche N de la diode et passer à une configuration correspondant à la courbe $E_B$ de la figure 3. On utilise maintenant pour une même tenue en tension inverse une résistivité de silicium beaucoup plus élevée. Sous tension inverse, la décroissance du champ à partir de la jonction sera lente (courbe $E_B$) et on détermine l'épaisseur de la couche N, $W_N$, pour obtenir la tenue en tension visée. On peut réduire cette épaisseur dans un rapport pratiquement égal à 2 par rapport au cas précédent. Ceci permettra donc de réduire la durée de vie à un niveau considérablement plus faible (en principe 4 fois plus faible) et donc d'obtenir des diodes beaucoup plus rapides pour lesquelles la valeur d'$I_{RM}$ est beaucoup plus faible que dans le cas précédent. Mais, comme on l'a vu, l'inconvénient est que la charge $Q_2$ est alors très faible et qu'il se produit de fortes surtensions à la commutation.

Pour résoudre les problèmes posés, il était proposé dans la demande de brevet susmentionnée une structure telle qu'illustrée en figure 5. La diode proposée est élaborée à partir d'un substrat de type $N^+$ et comprend les couches classiques de type N et de type $P^+$. En outre, cette diode comprend une couche intermédiaire de type N, dite $N_1$, entre le substrat de type $N^+$ et la couche faiblement dopée de type N. Comme cela est classique, les couches de type $N^+$ et $P^+$, ont des niveaux de dopage aussi élevés que possible, supérieurs à $10^{18}$ atomes/cm3. La couche N, quasiment intrinsèque, a un niveau de dopage de l'ordre de $10^{13}$ à quelques $10^{14}$ atomes/cm$^3$. Dans une configuration courante, la couche N1 a un niveau de dopage de l'ordre de quelques $10^{14}$ à $10^{16}$ atomes/cm3, mais on verra que ce niveau de dopage est fonction des caractéristiques de fonctionnement nominal de la diode. Les couches $N_1$ et N sont de préférence formées par épitaxies successives sur le substrat $N^+$. La couche $P^+$ est par exemple formée par diffusion dans la couche N.

La figure 6 représente en trait plein la variation de concentration de dopants dans la diode en fonction de l'épaisseur.

En pointillés, on a indiqué la concentration de porteurs libres en excès à l'instant $t_0$ du cycle de commutation. Cette quantité de porteurs dépend du courant nominal dans la diode et/ou de la vitesse de commutation imposée par le circuit.

La courbe E indique la distribution du champ électrique quand la diode est dans l'état bloqué, $W_E$ désignant l'extension de la zone déserte quand la diode est dans l'état bloqué pour la tension nominale qu'elle est amenée à supporter.

En reprenant les notations de la figure 4, lors du blocage de la diode, entre les instants $t_0$ et $t_1$, les porteurs injectés se trouvant dans la zone qui va être désertée à l'instant $t_1$ sont éliminés, et c'est une partie des porteurs situés dans la zone hachurée de la figure 6 qui va correspondre à la charge Q2 évacuée entre les instants t1 et t2.

Selon le brevet susmentionné, il est essentiel que ces porteurs soient en nombre suffisant pour que la transition entre les instants t1 et t2 ne soit pas trop courte et que l'on ne provoque pas ainsi une surtension $V_{RM}$ trop importante.

Pour ajuster la durée s'écoulant entre les instants t1 et t2, on joue sur l'épaisseur et sur le niveau de dopage de la couche N1. Ce niveau de dopage, intermédiaire entre les niveaux de dopage des couches N et $N^+$, devra être inférieur à la densité de charge injectée lors de la conduction directe.

Un inconvénient de la structure proposée en figure 6, correspondant au brevet susmentionné est que l'on est amené, par rapport à la structure de diode des figures 2 et 3 d'augmenter la largeur de la région N et donc d'augmenter la résistance à l'état passant de la diode.

La présente invention propose une autre solution, basée sur la possibilité de moduler la concentration en atomes d'or et donc la durée de vie, telle que mentionnée précédemment.

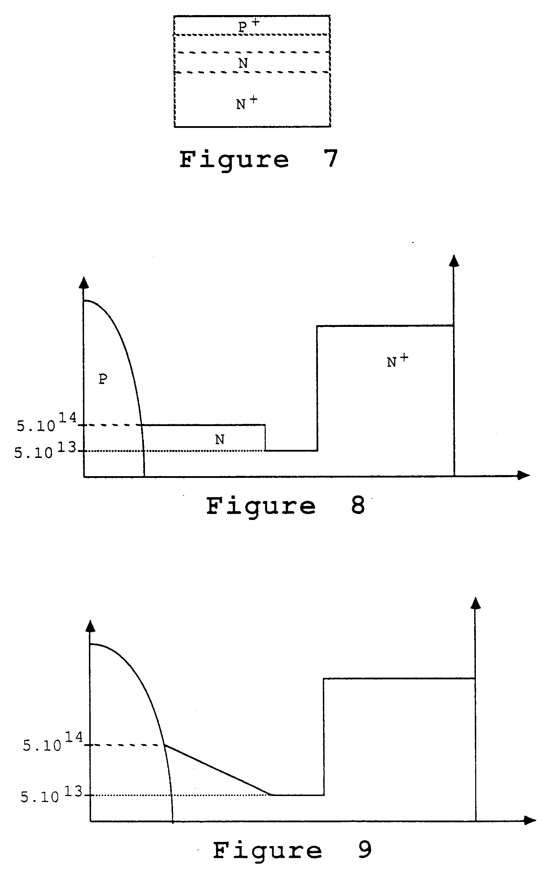

Pour ce faire, la présente invention propose une structure $P^+NN^+$ telle qu'illustrée en figure 7 dans laquelle la zone N présente une concentration d'atomes de porteurs telle qu'illustrée en figure 8 ou 9, c'est-à-dire une structure à plus haut niveau de dopage, selon un palier ou un gradient, du côté de la région $P^+$. Comme dans le brevet susmentionné, la couche N comprend une zone à très faible niveau de dopage (de l'ordre de $10^{13}$ à $10^{14}$ atomes/cm3) et une zone à plus fort niveau de dopage ($10^{14}$ à $10^{15}$ atomes/cm3) mais la position de ces zones par rapport aux couches $N^+$ et $P^+$ est inversée. Et la fonction de ces zones et le phénomène mis en oeuvre sont distincts. Le niveau de dopage au phosphore n'a pas d'effet direct mais est seulement utilisé pour moduler la concentration d'or et donc la durée de vie.

En effet, quand on réalise une diffusion d'atomes d'or, la concentration en atomes d'or substitutionnels sera plus élevée dans la région de la zone de type N présentant une concentration en phosphore plus élevée. Il en résulte qu'à la coupure, les porteurs stockés seront déchargés très rapidement dans la région plus dopée (plus faible durée de vie) et moins rapidement dans la région moins dopée (plus forte durée de vie), à la droite des figures 8 et 9. On dispose ainsi d'un réservoir de charge correspondant aux charges Q2 de la figure 4 permettant d'éviter les suroscillations lors du blocage. L'épaisseur totale de la couche de type N sera choisie égale ou très légèrement supérieure à l'étendue de la zone déserte pour la tension nominale de blocage de la diode.

La couche N à palier ou à gradient pourra être réalisée classiquement par épitaxie sur un substrat $N^+$, comme cela a été indiqué dans le brevet susmentionné.

La présente invention a été décrite dans le cas particulier où l'on souhaite moduler la concentration d'or au moyen de phosphore. On pourra envisager d'autres métaux que l'or, par exemple le platine, et d'autres dopants que le phosphore, par exemple le bore.

## Revendications

1. Procédé de fabrication d'une diode rapide $PNN^+$ dopée à l'or comprenant, sur un substrat de type $N^+$, une couche épitaxiée de silicium de type N de concentration dopants variant dans une plage de $10^{13}$ à $10^{15}$ atomes/cm$^3$ et une couche de type $P^+$ à haut niveau de dopage, l'épaisseur de la couche épitaxiée étant telle que, pour la tension nominale de fonctionnement à l'état bloqué, la zone déserte s'étend sur toute cette couche épitaxiée ou très légèrement moins que sur toute cette couche, caractérisé en ce qu'il comprend les étapes suivantes :

doper la couche épitaxiée par des atomes de phosphore avec un niveau de dopage plus élevé du côté de la couche P, et

réaliser une diffusion d'atomes d'or dans la toute structure ainsi obtenue.

2. Procédé de fabrication d'une diode rapide selon la revendication 1, caractérisé en ce qu'il consiste à former sur ledit substrat, du côté du substrate, une première sous-couche avec une concentration de phosphore constante de $10^{13}$ à $10^{14}$ atomes/cm$^3$ et, du côté de la couche $P^+$, une deuxième sous-couche avec une concentration de phosphore constante de $10^{14}$ à $10^{15}$ atomes/cm$^3$, ces deux sous-couches constituant la couche épitaxiée.

3. Procédé de fabrication d'une diode rapide selon la revendication 1, caractérisé en ce qu'il consiste à former sur ledit substrat, du côté du substrat, une première sous-couche avec une concentration de phosphore constante de $10^{13}$ à $10^{14}$ atomes/cm$^3$ et, du côté de la couche $P^+$, une deuxième sous-couche dans laquelle la concentration en atomes de phosphore varie linéairement en augmentant depuis l'emplacement où elle rejoint la première sous-couche jusqu'à l'emplacement de la jonction avec la couche de type $P^+$, ces deux sous-couches constituant la couche épitaxiée, et la première sous-couche ayant une épaisseur sensiblement moitié de l'épaisseur totale de cette couche épitaxiée.

4. Diode rapide $PNN^+$ dopée à l'or comprenant un substrat de type $N^+$, une couche épitaxiée de silicium de type N d'un niveau de dopage de $10^{13}$ à $10^{15}$ atomes/cm$^3$ et d'une épaisseur telle que, pour la tension nominale de fonctionnement à l'état bloqué, la zone déserte s'étend sur toute cette couche ou très légèrement moins que sur toute cette couche, et une couche de type $P^+$ à fort niveau de dopage, caractérisée en ce que la couche épitaxiée de type N comprend une région dopée au phosphore et à l'or à plus haut niveau de dopage en phosphore et en or du côté de la couche $P^+$ que du côté de la couche $N^+$.

5. Diode rapide $PNN^+$ dopée à l'or selon la revendication 4, caractérisée en ce que la couche épitaxiée comprend une première sous-couche du côté du substrat ayant une concentration en phosphore constante de $10^{13}$ à $10^{14}$ atomes/cm$^3$ et une deuxième sous-couche du côté de la couche P$^+$ ayant une concentration en phosphore constante de 10$^{14}$ à 10$^{15}$ atomes/cm$^3$, et en ce que la concentration en or dans la deuxième sous-couche est supérieure à celle dans la première sous-couche.

6. Diode rapide PNN$^+$ dopée à l'or selon la revendication 4, caractérisée en ce que la couche épitaxiée comprend, du côté du substrat, une première, sous-coche d'épaisseur sensiblement moitié de l'épaisseur totale de cette couche épitaxiée et ayant une concentration en phosphore constante de 10$^{13}$ à 10$^{14}$ atomes/cm$^3$ et une deuxième sous-couche, du côté de la couche P$^+$, dans laquelle la concentration en atomes de phosphore varie linéairement en augmentant depuis l'emplacement où la deuxième sous-couche rejoint la première sous-couche jusqu'à l'emplacement de la jonction avec la couche de type P$^+$, et en ce que la concentration en or dans les deux sous-couches varie suivant le profil de la concentration en phosphore dans ces deux sous-couches, la concentration en or dans la deuxième sous-couche augmentant depuis l'emplacement où celle-ci rejoint la première sous-couche jusqu'à l'émplacement de la jonction avec la couche de type P$^+$.

## Claims

1. A method for manufacturing a gold-doped PNN$^+$ high-speed diode comprising, on an N$^+$-type substrate, an N-type silicon epitaxied layer having a dopant concentration varying in a range of 10$^{13}$ to 10$^{15}$ atoms/cm$^3$ and a P$^+$-type layer having a high doping level, the thickness of the epitaxied layer being such that, for the operating nominal voltage at the blocked state, the depleted area extends through all or almost all the epitaxied layer, characterized in that it further comprises the following steps:

doping the epitaxied layer with phosphorus atoms at a higher level on the side of the P-type layer, and

diffusing gold atoms in all the resulting structure.

2. A method for manufacturing a high-speed diode according to claim 1, characterized in that it consists in forming on said substrate, on the substrate side, a first sub-layer with a constant phosphorus concentration of 10$^{13}$ to 10$^{14}$ atoms/cm$^3$ and, on the side of the P$^+$-type layer, a second sub-layer, having a phosphorus concentration of 10$^{14}$ to 10$^{15}$ atoms/cm$^3$, the two sub-layers forming the epitaxied layer.

3. A method for manufacturing a high-speed diode according to claim 1, characterized in that the phosphorus concentration linearly varies by increasing from the place where it meets the first sub-layer up to the junction with the P$^+$-type layer, said two sub-layers forming the epitaxied layer, and the first sub-layer having a thickness that is substantially one half of the full thickness of said epitaxied layer.

4. A gold-doped high-speed PNN$^+$ diode comprising an N$^+$-type substrate, an N-type silicon epitaxied layer having a thickness such that, for the nominal operating voltage at the blocked state, the depleted area extends through all or almost all said layer, and a P$^+$-type layer having a high doping level, characterized in that the N-type epitaxied layer comprises a gold and phosphorus doped region with a gold and phosphorus doping level higher on the side of the P$^+$-type layer than on the side of the N$^+$ layer.

5. A gold-doped high-speed PNN$^+$ diode according to claim 4, characterized in that the epitaxied layer comprises a first sub-layer on the substrate side having a constant phosphorus concentration of 10$^{13}$ to 10$^{14}$ atoms/cm$^3$ and a second sub-layer on the side of the P$^+$-type layer having a constant phosphorus concentration of 10$^{14}$ to 10$^{15}$ atoms/cm$^3$, and in that the gold concentration in the second sub-layer is higher than in the first sub-layer.

6. A gold-doped high-speed PNN$^+$ diode according to claim 4, characterized in that the epitaxied layer comprises, on the substrate side, a first sub-layer having a thickness that is substantially one half of the full thickness of said epitaxied layer and having a constant phosphorus concentration of 10$^{13}$ to 10$^{14}$ atoms/cm$^3$, and a second sub-layer, on the side of the P$^+$-type layer, in which the phosphorus atom concentration linearly varies by increasing from the place at which the second sub-layer contacts the first sub-layer up to the junction with the P$^+$-type layer, and in that the gold concentration in the two sub-layers varies in accordance with the profile of the phosphorus concentration in said two sub-layers, the gold concentration in the second sub-layer increasing from its interface with the first sub-layer up to the junction with the P$^+$-type layer.

## Patentansprüche

1. Verfahren zur Herstellung einer mit Gold dotierten schnellen PNN$^+$-Diode, die auf einem N$^+$-Substrat eine epitaktisch aufgebrachte N-Siliziumschicht mit einer im Bereich zwischen $10^{13}$ bis $10^{15}$ Atome pro Kubikzentimeter variierenden Konzentration der Dotierungsmittel sowie eine P$^+$-Schicht mit hoher Dotierung aufweist, wobei die Dicke der epitaktisch aufgebrachten Schicht derart ist, daß für die Nennspannung bei der Sperrfunktion die leere Zone sich über diese gesamte epitaktisch aufgebrachte Schicht erstreckt oder über zumindest einen Teil, der nur geringfügig kleiner als diese gesamte Schicht ist, dadurch gekennzeichnet, daß das Verfahren die folgenden Schritte aufweist:
Dotieren der epitaktisch aufgebrachten Schicht durch Phosphoratome mit einem gegenüber der P-Schicht höheren Dotierungsniveau und
- Ausfuhren einer Diffusion von Goldatomen in der gesamten derart erhaltenen Struktur.

2.  Verfahren zur Herstellung einer schnellen Diode nach Anspruch 1, dadurch gekennzeichnet, daß auf dem Substrat auf der Substratseite eine erste Unterschicht mit einer konstanten Phosphorkonzentration von $10^{13}$ bis $10^{14}$ Atome pro Kubikzentimeter und auf Seiten der P$^+$-Schicht eine zweite Unterschicht mit einer konstanten Phosphorkonzentration zwischen $10^{14}$ und $10^{15}$ Atome pro Kubikzentimeter ausgebildet wird.

3.  Verfahren zur Herstellung einer schnellen Diode nach Anspruch 1, dadurch gekennzeichnet, daß auf dem Substrat auf Seiten des Substrates eine erste Unterschicht mit einer konstanten Phosphorkonzentration von $10^{13}$ bis $10^{14}$ Atome pro Kubikzentimeter und auf Seiten der P$^+$-Schicht eine zweite Unterschicht ausgebildet wird, in der die Konzentration der Phosphoratome linear variiert und von dem Ort, wo sie die erste Unterschicht berührt bis zu dem Berührungspunkt mit der P$^+$-Schicht ansteigt, wobei diese beiden Unterschichten die epitaktisch aufgebrachte Schicht bilden und die erste Unterschicht eine Dicke aufweist, die im wesentlichen der Hälfte der gesamten Dicke der epitaktisch aufgebrachten Schicht entspricht.

4.  Mit Gold dotierte schnelle PNN$^+$-Diode mit einem N$^+$-Substrat, einer epitaktisch aufgebrachten N-Siliziumschicht mit einem Dotierungsniveau von $10^{13}$ bis $10^{15}$ Atome pro Kubikzentimeter und einer solchen Dicke, daß für die Nennspannung im Sperrbetrieb die leere Zone sich über diese gesamte Schicht erstreckt oder über zumindest einen Teil, der nur geringfügig kleiner als diese gesamte Schicht ist, und mit einer hochdotierten P$^+$-Schicht, dadurch gekennzeichnet, daß die epitaktisch aufgebrachte N-Schicht einen mit Phosphor und mit Gold dotierten Bereich aufweist, dessen Dotierungsniveau mit Phosphor und Gold auf Seiten der P$^+$-Schicht höher als auf Seiten der N$^+$-Schicht ist.

5.  Mit Gold dotierte schnelle PNN$^+$-Diode nach Anspruch 4, dadurch gekennzeichnet, daß die epitaktisch aufgebrachte Schicht eine erste Unterschicht auf Seiten des Substrates mit einer konstanten Phosphorkonzentration von $10^{13}$ bis $10^{14}$ Atome pro Kubikzentimeter und eine zweite Unterschicht auf Seiten der P$^+$-Schicht mit einer konstanten Phosphorkonzentration von $10^{14}$ bis $10^{15}$ Atome pro Kubikzentimeter aufweist, und daß die Goldkonzentration in der zweiten Unterschicht höher als diejenige in der ersten Unterschicht ist.

6.  Mit Gold dotierte schnelle PNN$^+$-Diode nach Anspruch 4, dadurch gekennzeichnet, daß die epitaktisch aufgebrachte Schicht auf Seiten des Substrates eine erste Unterschicht mit im wesentlichen der halben Gesamtdicke der epitaktisch aufgebrachten Schicht und mit einer konstanten Phosphorkonzentration von $10^{13}$ bis $10^{14}$ Atome pro Kubikzentimeter und eine zweite Unterschicht auf Seiten der P$^+$-Schicht aufweist, in der die Konzentration der Phosphoratome linear variiert, und zwar vom Ort, wo diese zweite Unterschicht die erste Unterschicht berührt bis zu dem Berührungspunkt mit der P$^+$-Schicht linear ansteigt, und daß die Goldkonzentration in diesen beiden Unterschichten entsprechend dem Verlauf der Phosphorkonzentration in diesen beiden Unterschichten variiert, wobei die Goldkonzentration in der zweiten Unterschicht von dem Ort, wo sie die erste Unterschicht berührt, bis zu dem Verbindungspunkt mit der P$^+$-Schicht ansteigt.

Figure 1A

Figure 1B

Figure 1C

**Figure 2**

**Figure 3**

**Figure 4**

**Figure 5**

**Figure 6**

$P^+$

N

$N^+$

**Figure 7**

P

N

$5.10^{14}$

$5.10^{13}$

$N^+$

**Figure 8**

$5.10^{14}$

$5.10^{13}$

**Figure 9**